# EUROPÄISCHE PATENTANMELDUNG

(11) **EP 2 738 937 A1**
(43) Veröffentlichungstag der Anmeldung: **04.06.2014**
(21) Anmeldenummer: 14156572.1
(22) Anmeldetag: 17.04.2012
(51) Int. Cl.: H03F 1/02, H03F 1/42, H01G 5/16, H01G 5/18

(54) **Quasi-breitbandiger Doherty-Verstärker und diesbezügliche Kondensatorschaltung**

(30) Priorität: 05.05.2011 DE 102011075312
(62) Teilanmeldung aus: 12718128.7
(71) Anmelder: Rohde & Schwarz GmbH & Co. KG, 81671 München (DE)
(72) Erfinder: Schenk, Lothar, 12555 Berlin (DE)
(74) Vertreter: Körfer, Thomas

(57) **Zusammenfassung**

Ein Verstärker verfügt über eine erste Verstärkerschaltung (16), eine zweite Verstärkerschaltung (17), eine erste Hybridkopplerschaltung (18) und einem Abschluss (3). Die Hybridkopplerschaltung (18) verfügt über einen Ausgangsanschluss (13) und einen Isolationsanschluss (12). Der Abschluss (3) ist dabei mit dem Isolationsanschluss (12) der Hybridkopplerschaltung (18) verbunden. Der Abschluss (3) umfasst einen ersten Kondensator (34) und/oder eine Induktivität (35), welche unmittelbar an dem Insolationsanschluss (12) der Hybridkopplerschaltung (18) angeordnet ist.

## Beschreibung

Die Erfindung betrifft einen Verstärker, insbesondere einen Doherty-Verstärker und eine diesbezügliche Kondensatorschaltung.

Um bei hohem Wirkungsgrad und hoher Linearität Hochfrequenzverstärker aufzubauen, werden herkömmlicherweise Doherty-Verstärker eingesetzt.

Aus dem europäischen Patent EP 1 609 239 B1 ist ein Doherty-Verstärker bekannt, welcher einen 3dB-Koppler gleichzeitig als Impedanztransformator für den Hauptverstärker und als Leistungskombinierer für den Haupt- und Hilfsverstärker einsetzt, indem das normalerweise mit dem Systemwellenwiderstand abgeschlossene entkoppelte Tor des 3dB-Kopplers mit einer kurzgeschlossenen oder leerlaufenden Leitung bestimmter Länge abgeschlossen wird. Die dort gezeigte Anordnung hat den Nachteil, dass ein Frequenzwechsel über die übliche Doherty-Bandbreite hinaus nicht möglich ist und der Platzbedarf für eine verlustarme Leitung relativ groß ist.

Der Erfindung liegt die Aufgabe zugrunde, einen Hochfrequenzverstärker und eine diesbezügliche Kondensatorschaltung zu schaffen, welcher bei hohem Wirkungsgrad und hoher Linearität einen geringen Platzbedarf erfordert.

Die Aufgabe wird erfindungsgemäß für die Vorrichtung durch die Merkmale des unabhängigen Anspruchs 1 und für die Kondensatorschaltung durch die Merkmale des unabhängigen Anspruchs 14 gelöst. Vorteilhafte Weiterbildungen sind Gegenstand der hierauf rückbezogenen Unteransprüche.

Ein erfindungsgemäßer Verstärker verfügt über eine erste Verstärkerschaltung, eine zweite Verstärkerschaltung, eine erste Hybridkopplerschaltung und einem Abschluss. Die Hybridkopplerschaltung verfügt über einen Ausgangsanschluss und einen Isolationsanschluss. Der Abschluss ist dabei mit dem Isolationsanschluss der Hybridkopplerschaltung verbunden. Der Abschluss umfasst einen ersten Kondensator und/oder eine Induktivität, welche unmittelbar an dem Insolationsanschluss der Hybridkopplerschaltung angeordnet ist. Es werden so ein hoher Wirkungsgrad und eine große Flexibilität des Einsatzes erreicht.

Die Erfindung basiert auf der Erkenntnis, dass die elektrischen Eigenschaften einer kurzgeschlossenen oder leerlaufenden Leitung bestimmter Länge durch diskrete Elemente nachgebildet werden können. Statt der relativ platzintensiven Leitungsstruktur kann ein Kondensator oder eine Induktivität eingesetzt werden. Anstatt einen für den Abschluss benötigten Wellenwiderstand mittels eines Kurzschlusses oder Leerlaufs zu erzeugen, welcher mittels einer Leitung an den Isolationsanschluss transformiert wird, wird erfindungsgemäß der benötigte Wellenwiderstand direkt am Isolationsanschluss mittels eines diskreten Kondensators und/oder einer diskreten Induktivität erzeugt. Der Platzbedarf der Schaltung lässt sich so drastisch reduzieren.

Vorzugsweise ist der Kondensator oder die Induktivität einstellbar. Der Frequenzbereich des Verstärkers kann so einfach eingestellt werden.

Ein Quasi-breitbandiges System kann erreicht werden, wenn die Einstellung automatisch, d.h. z.B. mittels eines Servomotors erfolgt. In Systemen, bei welchen Frequenzwechsel nur relativ selten notwendig sind und der Verstärker gleichzeitig nur bei einem Frequenzbereich arbeitet, kann der Verstärker so in einem sehr breiten Frequenzbereich eingesetzt werden.

Vorzugsweise kann zusätzlich zwischen dem Kondensator bzw. der Induktivität und einem Abschluss mittels eines 500hm - Widerstands umgeschaltet werden. Es ist so möglich zwischen einem Breitbandverstärker herkömmlicher Bauart mit relativ schlechtem Wirkungsgrad und einem abstimmbaren Doherty-Verstärker mit relativ gutem Wirkungsgrad umzuschalten.

Nachfolgend wird die Erfindung anhand der Zeichnung, in der vorteilhafte Ausführungsbeispiele der Erfindung dargestellt sind, beispielhaft beschrieben. In der Zeichnung zeigen:
- Fig. 1: ein erstes Ausführungsbeispiel des erfindungsgemäßen Verstärkers;
- Fig. 2: ein zweites Ausführungsbeispiel des erfindungsgemäßen Verstärkers;
- Fig. 3: ein drittes Ausführungsbeispiel des erfindungsgemäßen Verstärkers;
- Fig. 4: ein viertes Ausführungsbeispiel des erfindungsgemäßen Verstärkers;
- Fig. 5: ein fünftes Ausführungsbeispiel des erfindungsgemäßen Verstärkers;
- Fig. 6a: ein sechstes Ausführungsbeispiel des erfindungsgemäßen Verstärkers in einem ersten Schaltzustand;
- Fig. 6b: das sechste Ausführungsbeispiel des erfindungsgemäßen Verstärkers in einem zweiten Schaltzustand;
- Fig. 7: eine Detailansicht des sechsten Ausführungsbeispiels des erfindungsgemäßen Verstärkers;
- Fig. 8: ein erstes Ausführungsbeispiel der erfindungsgemäßen Kondensatorschaltung in einem ersten Zustand;
- Fig. 9: das erste Ausführungsbeispiel der erfindungsgemäßen Kondensatorschaltung in einem zweiten Zustand;
- Fig. 10: ein zweites Ausführungsbeispiel der erfindungsgemäßen Kondensatorschaltung in einer ersten Ansicht in einem ersten Zustand;
- Fig. 11: das zweite Ausführungsbeispiel der erfindungsgemäßen Kondensatorschaltung in einer zweiten Ansicht in dem ersten Zustand;
- Fig. 12: das zweite Ausführungsbeispiel der erfindungsgemäßen Kondensatorschaltung in einem zweiten Zustand;
- Fig. 13: ein drittes Ausführungsbeispiel der erfindungsgemäßen Kondensatorschaltung in einem ersten Zustand in einer ersten Ansicht;
- Fig. 14: das dritte Ausführungsbeispiel der erfindungsgemäßen Kondensatorschaltung in einem zweiten Zustand, und
- Fig. 15: das dritte Ausführungsbeispiel der erfindungsgemäßen Kondensatorschaltung in dem ersten Zustand in einer zweiten Ansicht.

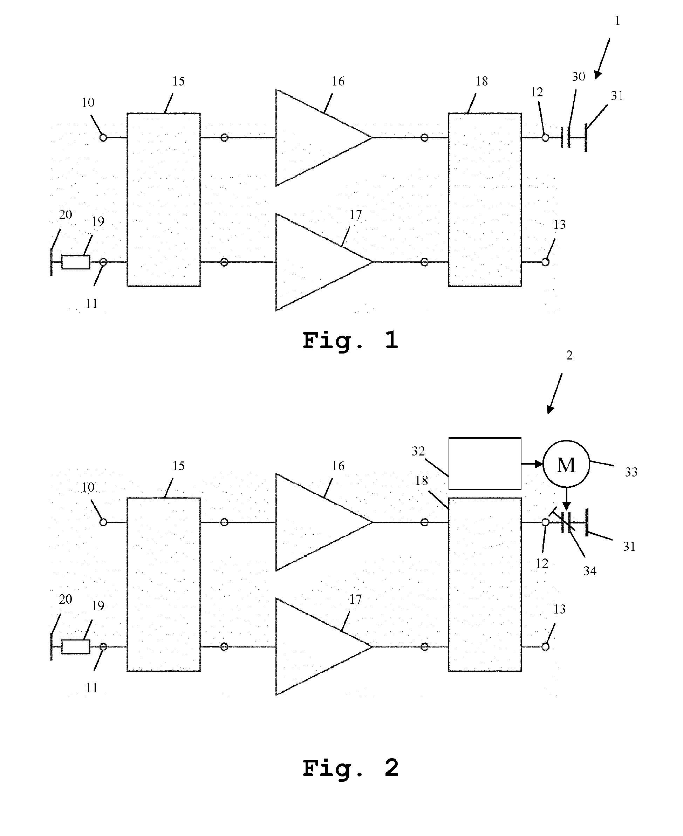

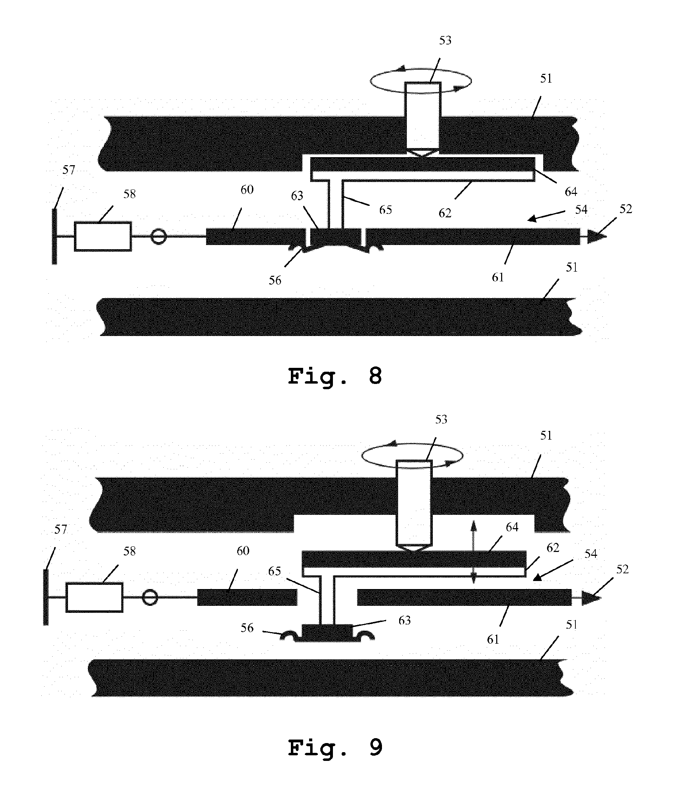

Zunächst wird anhand der Fig. 1 - 7 der Aufbau und die Funktionsweise des erfindungsgemäßen Verstärkers erläutert. Anschließend wird anhand von Fig. 8 - 15 auf den Aufbau und die Funktionsweise verschiedener Formen der erfindungsgemäßen Kondensatorschaltung eingegangen. Identische Elemente werden in ähnlichen Abbildungen z.T. nicht wiederholt dargestellt und beschrieben.

Fig. 1 zeigt ein erstes Ausführungsbeispiel des erfindungsgemäßen Verstärkers. Ein Leistungsteiler 15 verfügt über zwei Eingangsanschlüsse 10 und 11. An dem ersten Eingangseinschluss 10 kann ein Eingangssignal eingespeist werden. Der zweite Eingangsanschluss 11 ist mit einem Widerstand 19 und einem Masseanschluss 20 abgeschlossen. An den Leistungsteiler 15 sind weiterhin eine erste Verstärkerschaltung 16 und eine zweite Verstärkerschaltung 17 angeschlossen. Diese bilden den Hauptverstärker und den Hilfsverstärker gemäß dem Doherty-Prinzip. Ausgänge dieser Verstärkerschaltungen 16, 17 sind mit einer Hybridkopplerschaltung 18 verbunden. Ein Isolationsanschluss 12 dieser Hybridkopplerschaltung 18 ist mit einem diskreten Kondensator 30 und einem Masseanschluss 31 abgeschlossen. Der Kondensator 30 und der Masseanschluss 31 bilden dabei einen Abschluss 1.

Das zu verstärkende Signal wird dem Eingangsanschluss 10 des Leistungsteilers 15 zugeführt. Dieser teilt das Signal auf die beiden Verstärkerschaltungen 16, 17 auf, welche das Signal gemäß dem Doherty-Prinzip verstärken. Die verstärkten Signale werden von der Hybridkopplerschaltung 18 an ihrem Ausgangsanschluss 13 kombiniert. Durch den Kondensator 30 und den Masseanschluss 31 an dem Isolationsanschluss 12 der Hybridkopplerschaltung 18 wird ein optimaler Abschluss der Hybridkopplerschaltung 18 bei einer gegebenen Frequenz erreicht. Gleichzeitig wird ein sehr geringer Bauraum benötigt.

Eine weitere vorteilhafte Ausgestaltung ist, die erste Verstärkerschaltung 16 und die zweite Verstärkerschaltung 17 im System zu tauschen. So entsteht ein Doherty-Verstärker, der bei einer anderen Frequenz invers arbeitet. Ist die Arbeitspunktsteuerung in der Lage, die Konfiguration zu wechseln, ist die nutzbare Bandbreite des Systems verdoppelt. Es entsteht allerdings nicht unbedingt ein zusammenhängender Frequenzbereich.

Fig. 2 zeigt ein zweites Ausführungsbeispiel des erfindungsgemäßen Verstärkers. Die Schaltung entspricht weitgehend der Schaltung aus Fig. 1. Der diskrete und in seiner Kapazität feste Kondensator 30 aus Fig. 1 ist hier durch einen einstellbaren Kondensator 34 ersetzt. Die Kapazität dieses Kondensators 34 kann durch einen Servomotor 33, welcher von einer Steuereinrichtung 32 gesteuert wird, eingestellt werden. Der Kondensator 34, der Masseanschluss 31, der Servomotor 33 und die Steuereinrichtung 32 bilden dabei einen Abschluss 2.

Es ist so möglich, die Frequenz, für welche die Hybridkopplerschaltung 18 optimal abgeschlossen ist, einzustellen. Da der Verstärker gleichzeitig lediglich auf einer Frequenz arbeitet, ist es unproblematisch, dass die Einstellung des einstellbaren Kondensators 34 durch den Servomotor 33 eine gewisse Zeit in Anspruch nimmt.

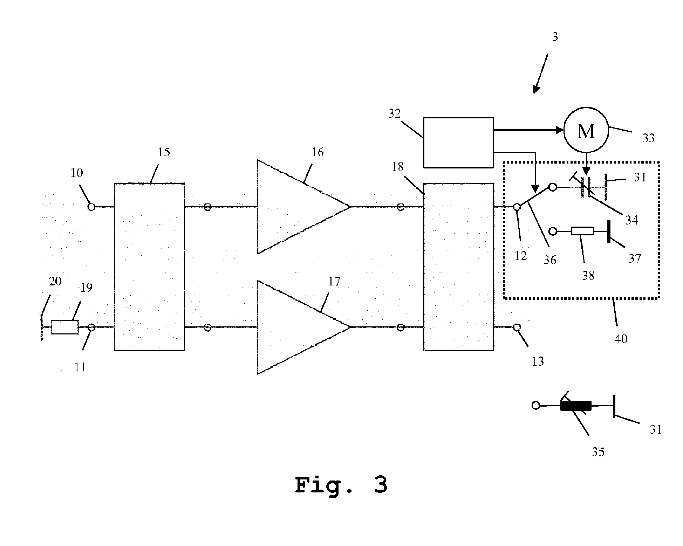

Fig. 3 zeigt ein drittes Ausführungsbeispiel des erfindungsgemäßen Verstärkers. Auch diese Darstellung entspricht weitgehend der Darstellung aus Fig. 1. Zusätzlich ist hier der Ausgangsanschluss 12 der Hybridkopplerschaltung 18 mit einem Schalter 36 verbunden. Der Schalter 36 schaltet zwischen dem einstellbaren Kondensator 34 aus Fig. 2 und einem ohmschen Abschlusswiderstand 38 in Serie mit einem Masseanschluss 37 um. Der Kondensator 34, der Masseanschluss 31, der Servomotor 33, die Steuereinrichtung 32, der Schalter 36, der ohmsche Widerstand 38 und der Masseanschluss 37 bilden dabei einen Abschluss 3.

Es wird so erreicht, dass zwischen einem Betrieb als Doherty-Verstärker und einem Betrieb als herkömmlichem breitbandigem Verstärker umgeschaltet werden kann. Zusätzlich zu der Umschaltung mittels des Schalters 36 müssen die Arbeitspunkte der Verstärkerschaltungen 16 und 17 angepasst werden. Der Schalter 36 wird dabei zusätzlich von der Steuereinrichtung 32 aus Fig. 2 gesteuert. Ein manuelles Eingreifen ist somit nicht notwendig.

Die Kombination aus dem Schalter 36, dem einstellbaren Kondensator 34 und dem alternativ anschaltbaren ohmschen Widerstand 38 bildet dabei eine Kondensatorschaltung 40. Die folgenden Figuren zeigen mögliche Ausgestaltung einer solchen Kondensatorschaltung. Alternativ kann wie unten dargestellt der einstellbare Kondensator 34 auch durch eine einstellbare Induktivität 35 ersetzt werden.

Alternativ können auch anstatt des Motors 33 und des einstellbaren Kondensators 34 ein Schalter 36 mit mehreren Kondensatoren fester Kapazität eingesetzt werden. Die Umschaltung erfolgt dann zwischen dem ohmschen Widerstand 38 und mehreren festen Kapazitäten. Auch ein Verzicht auf den Schalter 36 und die Steuereinrichtung 32 ist denkbar. In diesem Fall ist der Anschluss 12 über eine Lötbrücke mit dem ohmschen Widerstand 38 oder einem Kondensator verbunden.

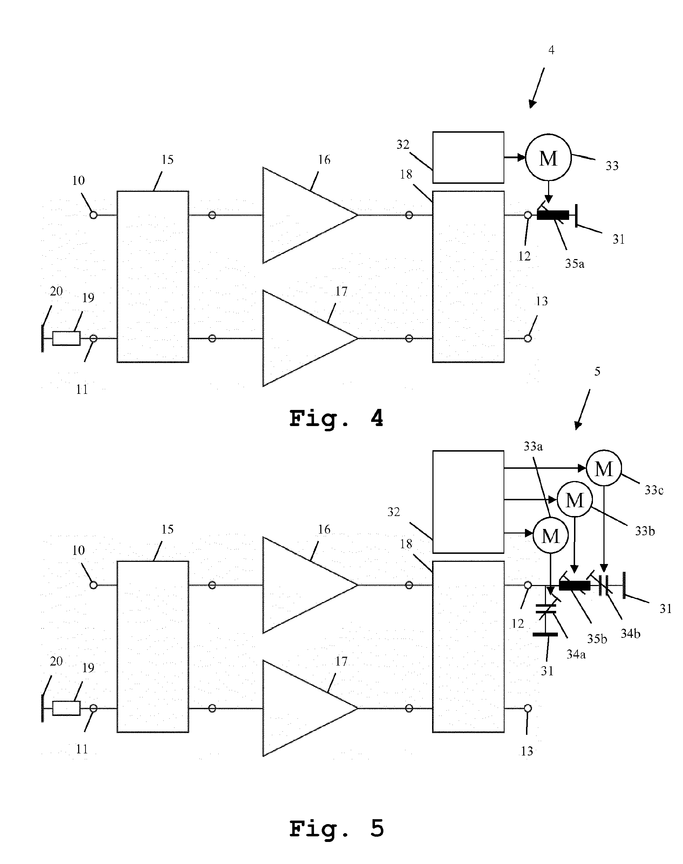

Fig. 4 zeigt ein viertes Ausführungsbeispiel des erfindungsgemäßen Verstärkers. Dieser Verstärker entspricht weitgehend dem Verstärker aus Fig. 2. Der einstellbare Kondensator 24 wurde hier jedoch durch eine einstellbare Induktivität 35a ersetzt.

In Fig. 5 wird ein fünftes Ausführungsbeispiel des erfindungsgemäßen Verstärkers gezeigt. Dieser Verstärker entspricht zum Teil dem Verstärker aus Fig. 2. Hier wurde der einstellbare Kondensator 34 durch einen ersten einstellbaren Kondensator 34a geschaltet gegen Masse 31, eine einstellbare Induktivität 35b und einen zweiten einstellbaren Kondensators 34b geschaltet gegen Masse 31 ersetzt. Diese werden jeweils durch einen eigenen Servomotor 33a, 33b und 33c eingestellt. Die Servomotoren 33a, 33b und 33c werden von der Steuereinrichtung 32 gesteuert. Durch diese Konfiguration kann eine noch größere Bandbreite des Verstärkers realisiert werden. Eine einfachere Realisierung kann erreicht werden, indem die Induktivität nicht einstellbar gewählt wird. Die Komplexität kann weiter reduziert werden, indem die beiden Einstellbaren Kondensatoren 34a und 34b synchron eingestellt werden.

Anstatt der Umschaltung zwischen verschiedenen Bauelementen mittels eines elektrisch gesteuerten Schalters 36, wie er in Fig. 3 dargestellt ist, ist auch der Einsatz eines manuell zu betätigenden Schalters möglich. Auch ist die Umschaltung zwischen Bauelementen, welche in den übrigen Figuren dargestellt sind, möglich. Im Folgenden wird ein Ausführungsbeispiel dargestellt, in welchem eine Umschaltung zwischen einem ohmschen Wiederstand, wie er in Fig. 3 dargestellt ist und einem π-Glied, wie es in Fig. 5 dargestellt ist.

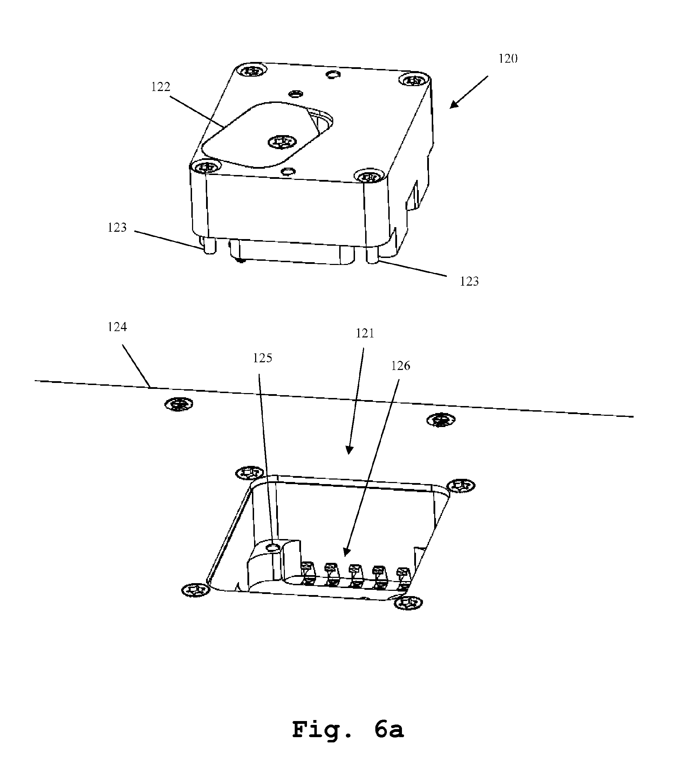

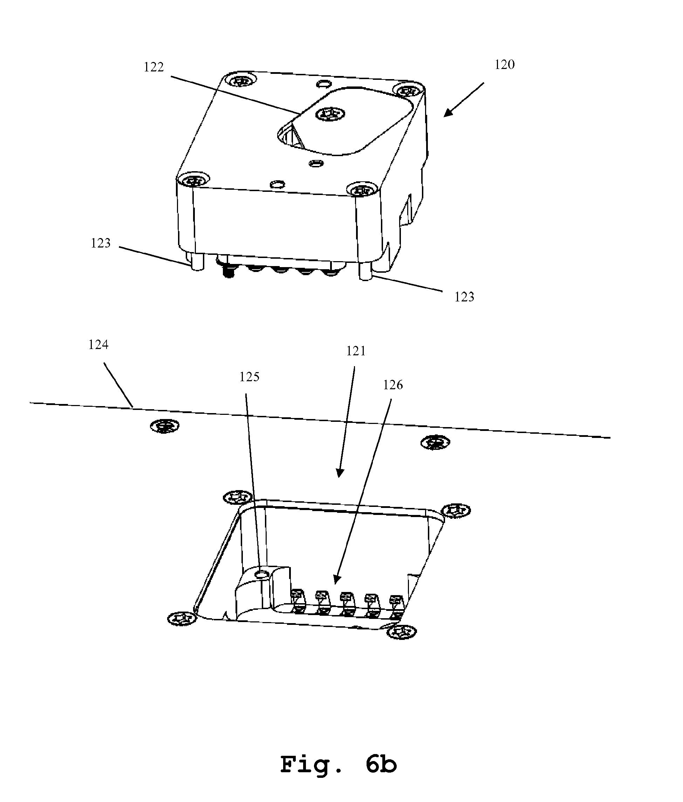

In Fig. 6a und Fig. 6b wird ein sechstes Ausführungsbeispiel des erfindungsgemäßen Verstärkers gezeigt. Der Verstärker weist hier ein Verstärkergehäuse 124 und ein Einsteckmodul 120 auf. Das Verstärkergehäuse 124 beinhaltet sämtliche Bauelemente des Verstärkers mit Ausnahme zumindest eines Teils der am Isolationsanschluss angeschlossenen Bauelemente. Das Einsteckmodul 120 beinhaltet zumindest einen Teil der am Isolationsanschluss anzuschließenden Bauelemente. Das Verstärkergehäuse 124 verfügt über eine Ausnehmung 121 zur Aufnahme des Einsteckmoduls 120.

Das Einsteckmodul 120 verfügt dabei über Führungsstifte 123, welche beim Einstecken des Einsteckmoduls 120 in die Ausnehmung 121 des Verstärkergehäuses 124 in Führungen 125 greifen und somit die Positionierung des Einsteckmoduls 120 in den Verstärkergehäuse 124 mit einer hohen Präzision ermöglichen.

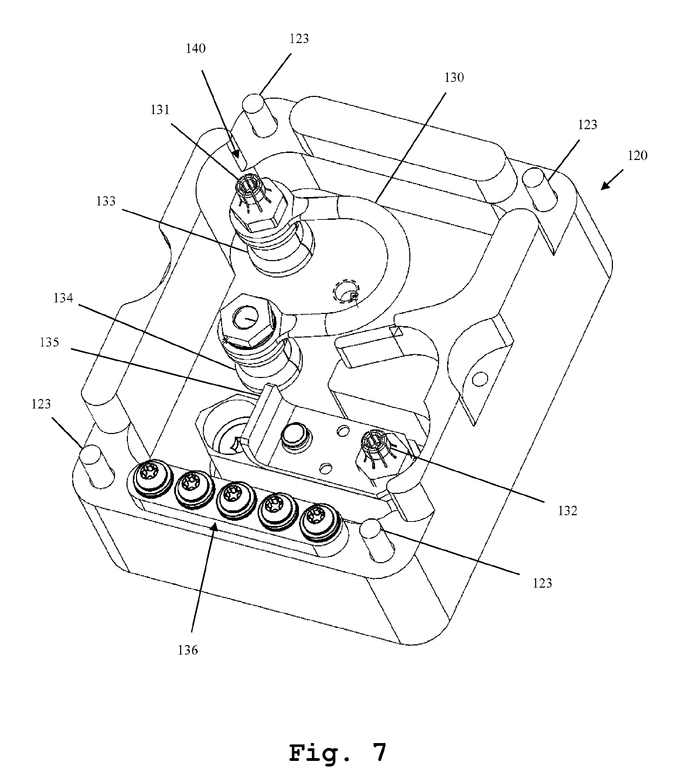

In der Ausnehmung 121 des Verstärkergehäuses 124 sind zusätzlich Federkontakte 126 zur Kontaktierung des Einsteckmoduls 120 angeordnet. Auf die Funktion der Federkontakte 126 wird anhand von Fig. 7 näher eingegangen. Das Einsteckmodul 120 verfügt darüber hinaus über einen entfernbaren Deckel 122. Wird der Deckel 122 entfernt, so können durch diese Öffnung abstimmbare Schaltungselemente abgestimmt werden. Auch auf diese Elemente wird anhand von Fig. 7 näher eingegangen.

Das Einsteckmodul 120 ist dabei derart ausgestaltet, dass es in verschiedenen Orientierungen in die Ausnehmung 121 eingesetzt werden kann. In Fig. 6a ist eine erste Orientierung des Einsteckmoduls 120 gegenüber der Ausnehmung 121 dargestellt. In Fig. 6b ist eine zweite Orientierung des Einsteckmoduls 120 gegenüber der Ausnehmung 121 dargestellt. Das Einstecken des Einsteckmoduls 120 in die Ausnehmung 121 in den verschiedenen Orientierungen bewirkt eine Verbindung unterschiedlicher Bauelemente innerhalb des Einsteckmoduls 120 mit dem übrigen Verstärker innerhalb des Verstärkergehäuses 124. D.h. das Einstecken in unterschiedlichen Orientierungen erfüllt die Funktion des Umschaltens zwischen verschiedenen angeschlossenen Bauelementen. Auch hierauf wird anhand von Fig. 7 näher eingegangen.

In Fig. 7 ist eine Detailansicht des sechsten Ausführungsbeispiels des erfindungsgemäßen Verstärkers gezeigt. Fig. 7 zeigt die der Darstellung in Fig. 6a und 6b gegenüberliegende Seite des Einsteckmoduls 120. Auch hier sind die Führungsstifte 123 deutlich erkennbar. Das Einsteckmodul 120 beinhaltet ein π-Glied 140, welches aus zwei einstellbaren Kondensatoren 133, 134 und einer Induktivität 130 gebildet ist. Bei den hier dargestellten Kondensatoren 133, 134 handelt es sich um einstellbare Zylinderkondensatoren. Durch den in Fig. 6a und 6b dargestellten Deckel 122, welcher auf der Unterseite des in Fig. 7 dargestellten Einsteckmoduls 120 angeordnet ist, können die Kapazitäten der Zylinderkondensatoren 133, 134 durch Schrauben abgestimmt werden. Auch der Einsatz anderer einstellbarer Elemente ist hier denkbar. Statt eines π-Glieds 140 könnte alternativ auch lediglich ein einzelner einstellbarer Kondensator oder ein beliebiges der in Fig. 1 - 5 dargestellten, mit dem Anschluss 12 verbundenen Elemente eingesetzt werden.

Mit einem ersten Anschluss des ersten Kondensators 133 ist zusätzlich ein Buchsenkontakt 131 verbunden. Mit diesem ersten Anschluss ist weiterhin die Induktivität 130 verbunden. Die Induktivität 130 wird hier durch eine halbe Wicklung, d.h. einen 180°-Drahtbogen, gebildet. Die Induktivität 130 verbindet den ersten Anschluss des ersten Kondensators 133 mit einem ersten Anschluss des zweiten Kondensators 134. Die jeweils zweiten Anschlüsse der Kondensatoren sind mit dem Gehäuse, d.h. mit Masse, verbunden.

Darüber hinaus beinhaltet das Einsteckmodul 120 einen zweiten Buchsenkontakt 132, welcher mit einer Kontaktbrücke 135 verbunden ist. Die Kontaktbrücke 135 ist dabei derart ausgebildet, dass sie bei einem Einführen des Einsteckmoduls 120 in die Ausnehmung 121 des Verstärkergehäuses 124 in einer ersten Orientierung eine Verbindung zu einer im Verstärkergehäuse 124 angeordneten 50 Ohm-Last herstellt. In dieser Orientierung stellt die Anschlussbuchse 132 direkt Kontakt zu dem Ausgang 12 des Verstärkers her. D.h. in dieser Orientierung verbindet die Kontaktbrücke 135 den Anschluss 12 des Verstärkers mit einer 50 Ohm-Last. Bezogen auf Fig. 3 entspricht dies der unteren Schalterstellung des Schalters 36. Diese erste Ausrichtung des Einsteckmoduls 120 entspricht somit dem herkömmlichen AB-Betrieb des Verstärkers.

Wird das Einsteckmodul 120 jedoch in der zweiten Ausrichtung in die Ausnehmung 121 des Verstärkergehäuses 124 eingesetzt, stellt die Kontaktbuchse 131 Kontakt zu dem Anschluss 12 her. Somit ist der Anschluss 12 mit dem π-Glied 140 verbunden. Diese zweite Ausrichtung des Einsteckmoduls 120 entspricht somit einer Verbindung eines π-Glieds, wie es in Fig. 5 dargestellt ist, mit dem Anschluss 12 des Verstärkers. Eine solche Verbindung entspricht dem Doherty-Betrieb des Verstärkers.

Zusätzlich verfügt das Einsteckmodul 120 über mehrere Kodierungsschrauben 136. Diese sind derart auf dem Einsteckmodul 120 angeordnet, dass sie bei Einführen des Einsteckmoduls 120 in die Ausnehmung 121 Kontakt zu den Federkontakten 126 herstellen. Die Federkontakte 126 sind dabei lediglich auf einer der beiden gegenüberliegenden Seiten der Ausnehmung 121 angeordnet, um lediglich bei der zweiten Ausrichtung des Einsteckmoduls 120, d.h. bei Betrieb des Verstärkers als Doherty-Verstärker Kontakt zu den Kodierungsschrauben aufnehmen zu können.

Durch die Anwesenheit der Kodierungsschrauben wird der jeweilige darunter befindliche Federkontakt 126 geschlossen. Die Federkontakte 126 sind dabei derart mit einer Steuereinrichtung verbunden, dass diese den Schaltzustand jedes einzelnen Federkontakts 126 kennt. Die Kodierungsschrauben 136 können einzeln eingeschraubt oder herausgeschraubt werden. Auch können sie einzeln entfernt werden. Das Bit-Muster, welches durch die Anwesenheit bzw. Abwesenheit der einzelnen Schrauben oder die Einschraubhöhe der einzelnen Schrauben gebildet wird, kodiert dabei die gegenwärtig eingestellte Abstimmungsfrequenz des π-Glieds 140. D.h. bei Einstellung eines Frequenzbereichs für den Doherty-Betrieb des erfindungsgemäßen Verstärkers wird zusätzlich manuell die eingestellte Frequenz als Bit-Muster in den Kodierungsschrauben 136 abgebildet. Der Verstärker erkennt somit über die Federkontakte 126, auf welche Frequenz das π-Glied 140 eingestellt ist.

Über die 5 dargestellten Kodierungsschrauben 136 sind prinzipiell 32 einstellbare Kanäle, d.h. 32 Kanäle denkbar. In der Praxis wird hier mit beispielsweise 12 Kanälen im UHF-Bereich gearbeitet. Bei jeder einzelnen Einstellung arbeitet das System dabei auf 3-4 Kanälen optimal und in den jeweils benachbarten Kanälen akzeptabel. Durch entsprechende Abstimmung lässt sich der Verstärker im Doherty-Modus im gesamten Frequenzbereich zwischen 470 und 862 MHz nutzen. Dabei gibt es 7 Standardabstimmungen die den gesamten Frequenzbereich abdecken. Die Standardabstimmungen können darüber hinaus auch auf bestimmte Kanäle innerhalb ihres Abstimmbereichs optimiert werden.

Die Fig. 8 und 9 zeigen ein erstes Ausführungsbeispiel der erfindungsgemäßen Kondensatorschaltung. An einem Anschluss 52, welcher dem Ausgangsanschluss 12 aus Fig. 1 - 5 entspricht, ist eine erste Kondensatorplatte 61 angeschlossen. Diese bildet zusammen mit einer zweiten Kondensatorplatte 64 einen Kondensator 54. Die zweite Kondensatorplatte 64 ist dabei mit einer motorgetriebenen Spindel 53 verbunden. Der Abstand der zweiten Kondensatorplatte 64 von der ersten Kondensatorplatte 61 wird mittels der motorgetriebenen Spindel 53 eingestellt. Die motorgetriebene Spindel 53 wird dabei von einem Servomotor angetrieben. Alternativ ist auch der Einsatz einer handgetriebenen Spindel möglich.

Verbunden mit der zweiten Kondensatorplatte 64 ist eine Isolatorplatte 62, welche einen Träger 65 aufweist. Der Träger 65 wiederum ist mit einem Leiterabschnitt 63 verbunden, welcher mit einem Schaltanschluss 56 verbunden ist. Mittels des Schaltanschlusses 56 kann die erste Kondensatorplatte 61 mit einem Leiterabschnitt 60 verbunden werden. Der Leiterabschnitt 60 wiederum ist mit einem Abschlusswiderstand 58 und einem Masseanschluss 57 verbunden. Der Kondensator 54 entspricht hier dem einstellbaren Kondensator 34 aus Fig. 2 - 3. Der Schaltanschluss 56 entspricht hier dem Schalter 36 aus Fig. 2 - 3. Der Abschlusswiderstand 58 und der Masseanschluss 57 entsprechen hier dem Abschlusswiderstand 38 und dem Masseanschluss 37 aus Fig. 3.

In Fig. 8 ist ein erster Zustand der Kondensatorschaltung gezeigt. Die motorgetriebene Spindel 53 hat die zweite Kondensatorplatte 64 auf einen maximalen Abstand von der ersten Kondensatorplatte 61 gebracht. Die Isolatorplatte 62 und der Träger 65 ziehen den Leiterabschnitt 63 und damit auch den Schaltabschluss 56, welcher hier als Kontaktfeder realisiert ist, an die erste Kondensatorplatte 61 und den Leiterabschnitt 60. Die erste Kondensatorplatte 61, der Schaltanschluss 56, der Leiterabschnitt 63 und der Leiterabschnitt 60 sind somit elektrisch miteinander verbunden. Der Anschluss 52 ist somit elektrisch mit dem Abschlusswiderstand 58 und über diesen mit dem Masseanschluss 57 verbunden. Dies entspricht der unteren Schalterstellung des Schalters 36 aus Fig. 3.

In Fig. 9 ist ein zweiter Zustand der Kondensatorschaltung gezeigt. Die motorgetriebene Spindel 53 hat die zweite Kondensatorplatte 54 und damit auch die Isolatorplatte 62, den Träger 65, den Leiterabschnitt 63 und den Schaltanschluss 56 nach unten bewegt. Der Schaltanschluss 56 hat den Kontakt zu der ersten Kondensatorplatte 61 und den Leiterabschnitt 60 verloren. Dies entspricht der oberen Schalterstellung des Schalters 36 aus Fig. 3. Durch den Abstand zwischen der ersten Kondensatorplatte 61 und der zweiten Kondensatorplatte 64 wird die Kapazität des Kondensators 54 eingestellt. D.h. es wird an die Betriebsfrequenz des Verstärkers, in welchem diese Kondensatorschaltung eingesetzt werden kann, so angepasst.

Da die Isolatorplatte 62 und der Träger 65 aus einem nichtleitenden Material bestehen, beeinflussen Sie den Feldverlauf des Kondensators 54 nur unwesentlich. Durch Fertigung der Isolatorplatte 62 und des Trägers 65 aus einem Material, welches eine ähnliche Dielektrizitätskonstante aufweist wie das umgebende Medium, z.B. Luft, kann der Einfluss weiter reduziert werden.

In der in Fig. 8 gezeigten Schalterstellung wirkt die erste Kondensatorplatte 61 lediglich als Leiter, welcher den Anschluss 52 mit dem Abschlusswiderstand 58 verbindet. Der Abstand zu der zweiten Kondensatorplatte 64 ist dabei so groß, dass kein nennenswerter Effekt auftritt. Die zweite Kondensatorplatte 54 liegt dabei über die motorgetriebene Spindel und das Gehäuse 51 auf Massepotential.

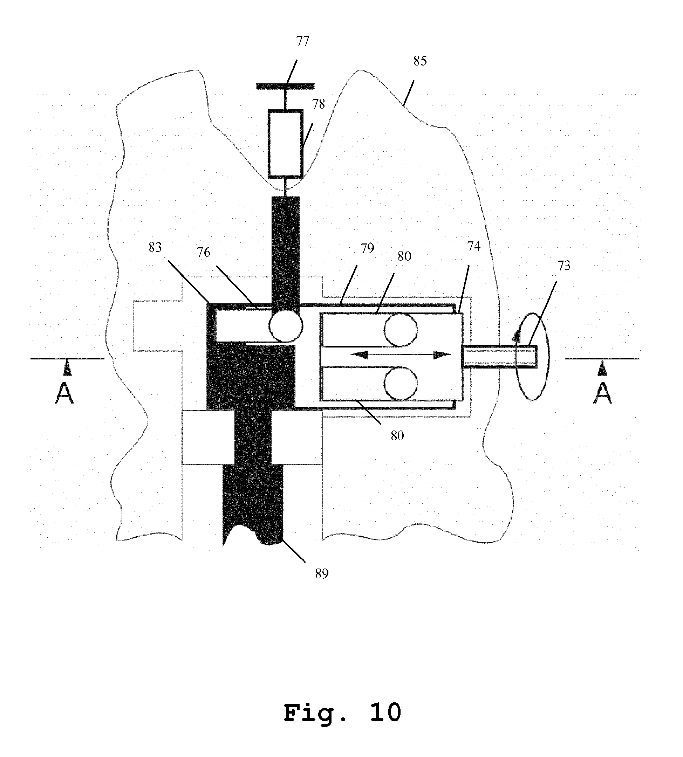

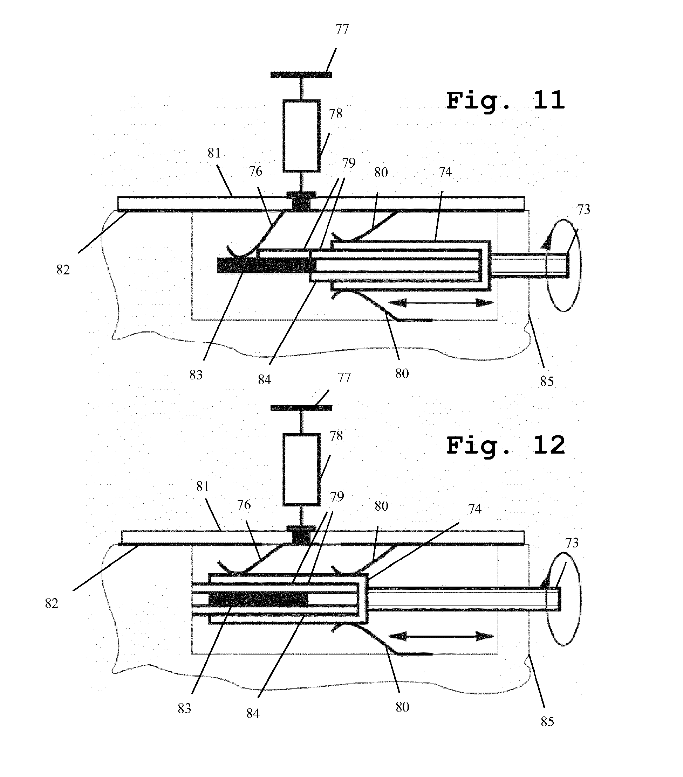

Fig. 10 - 12 zeigen ein zweites Ausführungsbeispiel der erfindungsgemäßen Kondensatorschaltung. Die Ansicht der Fig. 11 und Fig. 12 entspricht dem Schnitt entlang der Schnittlinie A aus Fig. 10. Ein Gehäuse 85 liegt auf Massepotential. Das Gehäuse 85 ist auf einer Seite mittels einer Leiterplatte 81, welche auf ihrer Unterseite mit einer metallisierten Masselage 82 versehen ist, abgedeckt. In einer Aussparung des Gehäuses 85 ist ein Leiter 89 angeordnet. Dieser ist hier als Flachbandleiter realisiert. Das obere Ende des Leiters 89 ist dabei zu einer ersten Kondensatorplatte 83 ausgebildet.

In einem ersten Zustand, welcher in den Fig. 10 und Fig. 11 gezeigt ist, befindet sich die erste Kondensatorplatte 83 über einen Schaltanschluss 76, welcher hier als Kontaktfeder realisiert ist, in Verbindung mit einem Abschlusswiderstand 78 und einem Masseanschluss 77. Dies entspricht der unteren Schalterstellung aus Fig. 3. Der Leiter 89 steht an seinem unteren Ende dabei mit dem Isolationsanschluss des Verstärkers, in welchem die hier gezeigte Kondensatorschaltung eingesetzt ist, in Verbindung.

Eine motorgetriebene Spindel 73, welche beispielsweise von dem Servomotor 33 aus Fig. 3 angetrieben werden kann, ist mit einer zweiten Kondensatorplatte 74 verbunden. Die zweite Kondensatorplatte 74 ist mit einer Isolatorplatte 79 verbunden. Die Isolatorplatte 79 weist im Bereich des Schaltanschlusses 76 einen Vorsprung auf. Die zweite Kondensatorplatte 74 ist dabei derart ausgebildet, dass sie die erste Kondensatorplatte umfassen kann. Auf ihrer Oberseite wird sie dabei durch die erste Isolatorplatte 69 von der ersten Kondensatorplatte 83 getrennt. Auf ihrer Unterseite wird Sie dabei von einer zweiten Isolatorplatte 84, welche ebenfalls mit der zweiten Kondensatorplatte 74 verbunden ist, auf Abstand zu der ersten Kondensatorplatte 83 gehalten.

In einem ersten Zustand, welcher in Fig. 10 und Fig. 11 gezeigt ist, steht der Schaltanschluss 76 in Kontakt mit der ersten Kondensatorplatte 83. Es besteht somit eine leitende Verbindung dem Anschluss 82 und dem Abschlusswiderstand 78. In einem zweiten Zustand, welcher in Fig. 12 gezeigt ist, hat die motorgetriebene Spindel 73 die zweite Kondensatorplatte 74 und die erste und zweite Isolatorplatte 79, 84 in Richtung der ersten Kondensatorplatte 83 bewegt. Der Vorsprung der ersten Isolatorplatte 79 hat den Schaltanschluss 76 von der ersten Kondensatorplatte 83 abgehoben und so die elektrische Verbindung der Leitung 89 zu dem Abschlusswiderstand 78 unterbrochen. Gleichzeitig wurde die zweite Kondensatorplatte 74 um die erste Kondensatorplatte 83 gestülpt. Die Kapazität zwischen der ersten Kondensatorplatte 83 und der zweiten Kondensatorplatte 74 ist hierdurch signifikant angestiegen. Die zweite Kondensatorplatte 74 steht dabei in elektrischem Kontakt mit Kontaktfedern 80, welche einen Kontakt zu dem auf Massepotenzial befindlichen Gehäuse 85 herstellen. Über die genaue Positionierung der zweiten Kondensatorplatte 74 mittels der motorgetriebenen Spindel 73 kann die gewünschte Kapazität eingestellt werden. Eine Einstellung der Betriebsfrequenz des Verstärkers, in welchem die hier gezeigte Kondensatorschaltung eingesetzt werden soll, ist so möglich.

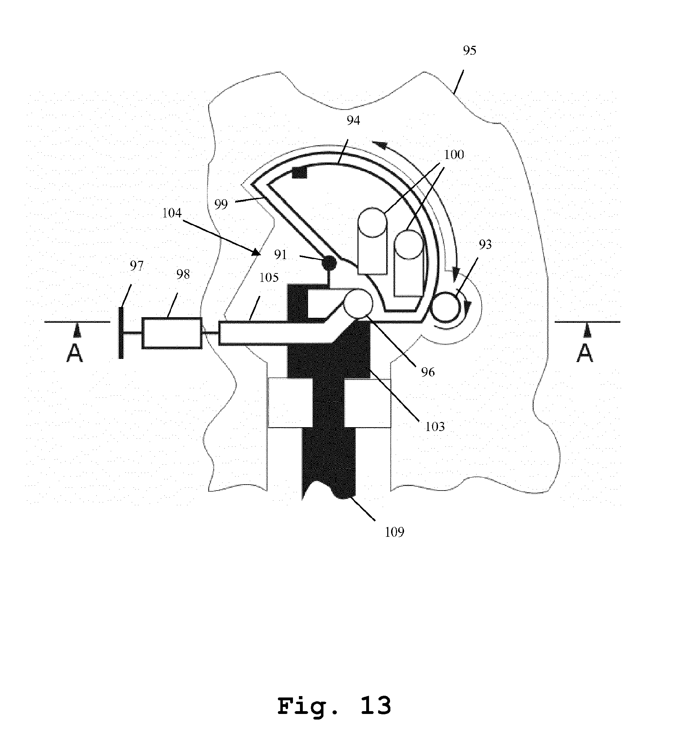

Die Fig. 13 - 15 zeigen ein weiteres Ausführungsbeispiel der erfindungsgemäßen Kondensatorschaltung. Zur Einstellung der Kapazität wird hier ein Drehkondensator eingesetzt. In einem auf Massepotenzial befindlichen Gehäuse 95 ist eine Ausnehmung 104 angeordnet. In die Ausnehmung 104 ragt das Ende einer Leitung 109, welche zu einer ersten Kondensatorplatte 103 verbreitert ist. In der Ausnehmung 104 ist weiterhin eine zweite Kondensatorplatte 94 angeordnet, welche um eine Drehachse 91 drehbar ist. Die zweite Kondensatorplatte 94 ist dabei derart ausgebildet, dass sie die ersten Kondensatorplatte 103 umfassen kann. Die zweite Kondensatorplatte 94 ist dabei mit einer Isolatorplatte 99 verbunden, welche ebenfalls so ausgelegt ist, dass sie die erste Kondensatorplatte 103 umfassen kann. Die Isolatorplatte 99 steht dabei in Kontakt mit einer motorgetriebenen Spindel 93. Mittels eines Reibrades oder eines Zahnrades greift die motorgetriebene Spindel 93 tangential am Umfang der Platte an und dreht die Isolatorplatte 99 und die zweite Kondensatorplatte 94 um die Drehachse 91. Alternativ ist ein Antrieb direkt durch die Drehachse 91 möglich. Es kann dann auf die motorgetriebene Spindel 93 verzichtet werden.

Ein Schaltanschluss 96, welcher hier als Kontaktfeder ausgeführt ist, ist mittels eines Leiterabschnitts 105 mit einem Abschlusswiderstand 98 und über diesen mit einem Masseanschluss 97 verbunden.

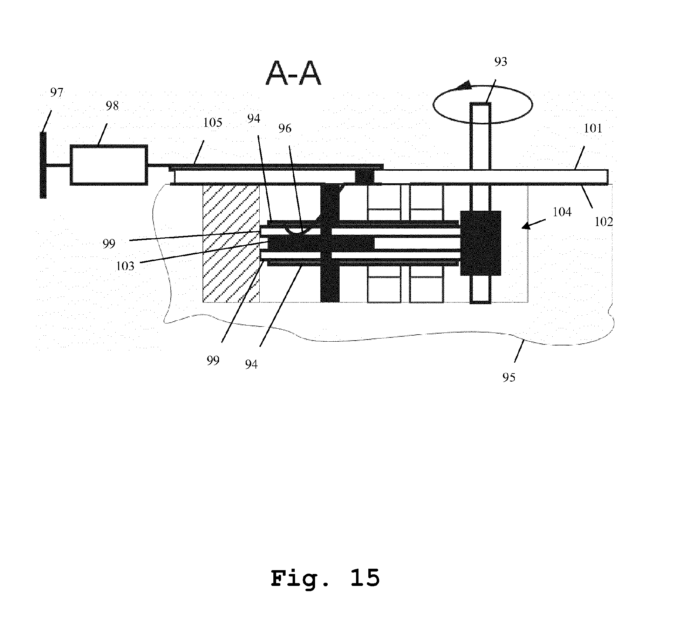

In einem ersten Zustand, welcher in Fig. 13 und Fig. 15 dargestellt ist, stellt der Schaltanschluss 96 einen Kontakt zwischen der ersten Kondensatorplatte und dem Leiterabschnitt 105 her. Die Leitung 109 ist somit elektrisch mit dem Abschlusswiderstand 98 und über diesen mit dem Masseanschluss 97 verbunden. Dies entspricht der unteren Schalterstellung aus Fig. 3.

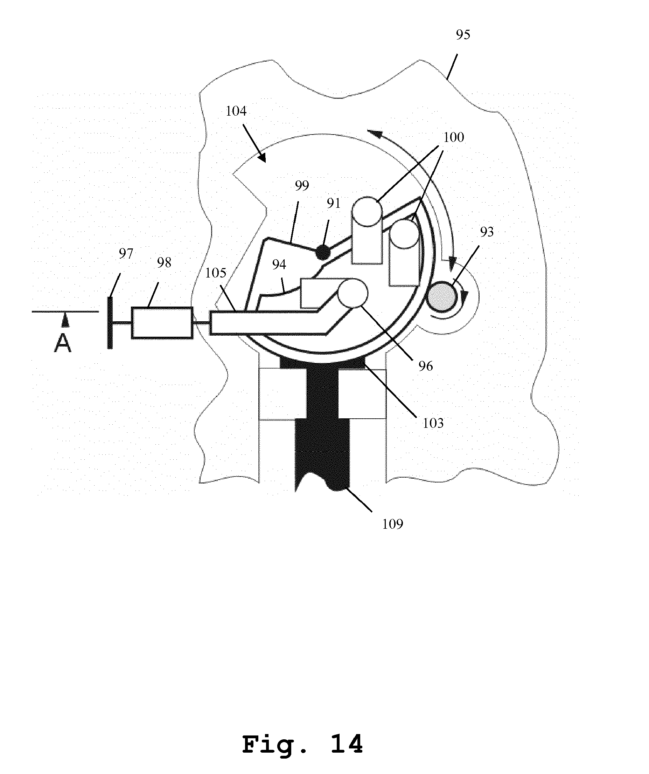

In einem zweiten Zustand, welcher in Fig. 14 dargestellt ist, ist die zweite Kondensatorplatte 94 und die Isolatorplatte 99 derart um die Drehachse 91 gedreht, dass die Isolatorplatte 99 und die zweite Kondensatorplatte 94 den Kontakt des Schaltanschlusses 96 zu der ersten Kondensatorplatte unterbrechen. Die zweite Kondensatorplatte 94 und die Isolatorplatte 99 umfassen nun die erste Kondensatorplatte 103. Die zweite Kondensatorplatte 94 steht über Kontaktfedern 100 in elektrischer Verbindung mit dem auf Massepotenzial befindlichen Gehäuse 95. Der hier gezeigte Zustand entspricht der oberen Schalterstellung aus Fig. 3. Über den Drehwinkel der zweiten Kondensatorplatte 94 um die Drehachse 91 kann die Überlappung der ersten Kondensatorplatte 103 und der zweiten Kondensatorplatte 94 eingestellt werden. Der Grad der Überlappung stellt dabei die Kapazität des resultierenden Kondensators ein. Die Isolatorplatte 99 stellt dabei einen konstanten Abstand zwischen der ersten Kondensatorplatte 103 und der zweiten Kondensatorplatte 94 sicher. Über den Drehwinkel wird somit die Betriebsfrequenz eines Verstärkers, in welchem die hier gezeigte Kondensatorschaltung eingesetzt wird, eingestellt.

Wie bereits anhand von Fig. 11 - 12 dargestellt, weist auch hier das Gehäuse 95 eine Abdeckung mittels einer Leiterplatte 101 auf. Auch hier ist die Unterseite der Leiterplatte 101 mit einer Metallisierung 102 versehen.

Die Erfindung ist nicht auf das dargestellt Ausführungsbeispiel beschränkt. Insbesondere kann die gezeigte Kondensatorschaltung auch in anderen Schaltungen eingesetzt werden. Auch eine Umschaltung bzw. ein Umstecken verschiedener Bauelemente als dargestellt ist denkbar. Alle vorstehend beschriebenen Merkmale oder in den Figuren gezeigten Merkmale sind im Rahmen der Erfindung beliebig vorteilhaft miteinander kombinierbar.

## Patentansprüche

1. Kondensatorschaltung mit einer ersten Kondensatorplatte (61, 83, 103), einer zweiten Kondensatorplatte (64, 74, 94), einer Isolatorplatte (62, 79, 99) und einem Schaltanschluss (56, 76, 96),
wobei die zweite Kondensatorplatte (64, 74, 94) mit der Isolatorplatte (62, 79, 99) fest verbunden ist,
wobei die zweite Kondensatorplatte (64, 74, 94) und die Isolatorplatte (62, 79, 99) gegenüber der ersten Kondensatorplatte (61, 83, 103) beweglich sind,
wobei der Schaltanschluss (56, 76, 96) trennbar mit der ersten Kondensatorplatte (61, 83, 103) verbunden ist.

2. Kondensatorschaltung nach Anspruch 1,
**dadurch gekennzeichnet,**
**dass** die Isolatorplatte (62, 79, 99) und der Schaltanschluss (56, 76, 96) derart ausgebildet sind, dass die Isolatorplatte (62, 79, 99) bei Annäherung der ersten Kondensatorplatte (61, 83, 103) und der zweiten Kondensatorplatte (64, 74, 94) den Schaltanschluss (56, 76, 96) von der ersten Kondensatorplatte (61, 83, 103) trennt.

3. Kondensatorschaltung nach Anspruch 1 oder 2,
**dadurch gekennzeichnet,**
**dass** die Isolatorplatte (62, 79, 99) und der Schaltanschluss (56, 76, 96) derart ausgebildet sind, dass der Schaltanschluss (56, 76, 96) bei Entfernung der ersten Kondensatorplatte (61, 83, 103) von der zweiten Kondensatorplatte (64, 74, 94) mit der ersten Kondensatorplatte (61, 83, 103) in Kontakt tritt.

4. Kondensatorschaltung nach einem der Ansprüche 1 bis 3,
**dadurch gekennzeichnet,**
**dass** die zweite Kondensatorplatte (74) und die Isolatorplatte (79) mittels eines Schiebelagers verschiebbar gegenüber der ersten Kondensatorplatte (83) gelagert sind.

5. Kondensatorschaltung nach einem der Ansprüche 1 bis 4,
**dadurch gekennzeichnet,**
**dass** die zweite Kondensatorplatte (94) und die Isolatorplatte (99) mittels eines Drehlagers drehbar gegenüber der ersten Kondensatorplatte (103) gelagert sind.

6. Kondensatorschaltung nach einem der Ansprüche 1 bis 5,
**dadurch gekennzeichnet,**
**dass** der Schaltanschluss (76, 96) eine Kontaktfeder ist, und
**dass** die Kontaktfeder durch Federspannung in Kontakt mit der ersten Kondensatorplatte (83, 103) steht.

7. Kondensatorschaltung nach Anspruch 6,
**dadurch gekennzeichnet,**
**dass** die Isolatorplatte (79, 99) derart ausgebildet ist, dass sie sich bei Annäherung der ersten Kondensatorplatte (83, 103) und der zweiten Kondensatorplatte (74, 94) zwischen die Kontaktfeder und die erste Kondensatorplatte (74, 94) schiebt.

8. Kondensatorschaltung nach einem der Ansprüche 1 bis 7,
**dadurch gekennzeichnet,**
**dass** die Isolatorplatte (62) mittels eines Trägers (65) mit einem Leiterabschnitt (63) verbunden ist, und
**dass** der Schaltanschluss (56) den Leiterabschnitt (63) mit der ersten Kondensatorplatte (61) verbindet bzw. den Leiterabschnitt (63) von der ersten Kondensatorplatte (61) trennt.
